# EUROPÄISCHE PATENTSCHRIFT

(11) **EP 1 908 090 B1**
(45) Veröffentlichungstag und Bekanntmachung des Hinweises auf die Patenterteilung: **28.11.2012**
(21) Anmeldenummer: 05760670.9
(22) Anmeldetag: 26.07.2005
(51) Int. Cl.: H01J 37/34, C23C 14/35

(54) **VERFAHREN ZUR HERSTELLUNG MAGNETRONBESCHICHTETER SUBSTRATE UND MAGNETRONSPUTTERQUELLE**
METHOD FOR THE PRODUCTION OF MAGNETRON-COATED SUBSTRATES AND MAGNETRON SPUTTER SOURCE
PROCEDE DE PRODUCTION DE SUBSTRATS ENDUITS PAR PULVERISATION MAGNETRON ET SOURCE DE PULVERISATION MAGNETRON

(30) Priorität: 28.09.2004 CH 15782004
(43) Veröffentlichungstag der Anmeldung: 09.04.2008
(73) Patentinhaber: OC Oerlikon Balzers AG, 9496 Balzers (LI)
(72) Erfinder: WEICHART, Jürgen, FL-9496 Balzers (LI)
(74) Vertreter: Troesch Scheidegger Werner AG
(86) Internationale Anmeldenummer: PCT/CH2005/000441
(87) Internationale Veröffentlichungsnummer: WO 2006/034598

(56) Entgegenhaltungen:
- EP-A- 0 820 088
- EP-A- 0 858 095
- EP-A- 0 945 524
- WO-A-98/02597
- WO-A-2004/036616
- DE-A1- 3 908 252
- US-A- 5 399 253
- US-A1- 2004 050 690

## Beschreibung

Die vorliegende Erfindung betrifft ein Verfahren zum Herstellen magnetronbeschichteter Substrate sowie eine Magnetronquelle.

### Definitionen

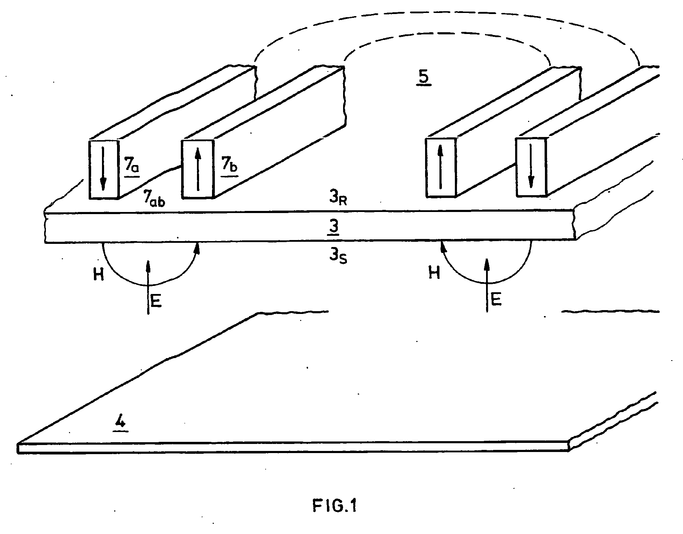

In Fig. 1 ist schematisch der Aufbau einer Magnetronquelle dargestellt. Sie hat ein Target 3 mit einer Sputterfläche 3_{S}, von welcher Targetmaterial abgesputtert wird und reaktiv oder nichtreaktiv auf das Substrat 4 abgelegt wird. Rückseitig 3_{R} des Targets ist eine Magnetanordnung 5 vorgesehen. Sie hat mindestens ein Paar umlaufender Magnetschleifen 7ₐ und 7_{b}, welche, der- Targetrückseite 3_{R} zugewandt, Flächen inverser magnetischer Polarität haben. Die Magnetschleifen 7ₐ bzw. 7_{b} bilden je in sich geschlossene Schleifen, wobei "geschlossen" durchaus auch voneinander beabstandete Magnete umfasst, solange durch die beiden Magnetschleifen an der Sputterfläche 3_{S} des Targets 3 in sich geschlossene Schleifen des Magnetronmagnetfeldes H erzeugt werden. Bezüglich der Erzeugung des umlaufenden, tunnelförmigen Magnetronmagnetfeldes H bilden die beiden Magnetschleifen 7ₐ und 7_{b} ein zusammenwirkendes Magnetschleifenpaar 7_{ab}. Das Magnetronmagnetfeld H wird, wie schematisch dargestellt, durch ein zwischen einer Anode und dem als Kathode beschalteten Target 3 erzeugtes elektrisches Feld E gekreuzt. Aufgrund des Magnetronmagnetfeldes H sowie des elektrischen Feldes E ergibt sich der bekannte Elektronenfallen-Effekt im Bereich des tunnelförmigen Magnetronmagnetfeldes H, was dort zu einer erhöhten Plasmadichte und einer erhöhten Sputterwirkung führt. Das Resultat ist im Bereich des Magnetronmagnetfeldes ein über der Betriebszeit zunehmend tiefer, umlaufender Erosionsgraben in der Sputterfläche 3_{S}. Wir nennen eine geschlossen umlaufende, wie auch immer geformte Schleife von Magneten, welche der Targetrückseite 3_{R} eine der beiden magnetischen Polaritäten präsentiert, eine Magnetschleife. Gemäss Fig. 1 sind zwei solche Magnetschleifen 7ₐ, 7_{b} vorhanden.

Zwei einander benachbarte, derartige Magnetschleifen bilden ein Magnetschleifenpaar gemäss 7_{ab} von Fig. 1 wenn sie eine umlaufende Schleife des tunnelförmigen Magnetronmagnetfeldes H erzeugen. Die Magnetanordnung 5 kann eine oder mehrere umlaufende Magnetschleifen nebst zur Formung der Magnetronmagnetfeldschleifen gesondert platzierter zusätzlicher Magnete enthalten. Das elektrische Feld E zwischen (nicht dargestellter) Anode und Targetkathode kann mit DC, gepulstem DC, überlagertem DC und AC sowie AC bis in den Hochfrequenzbereich erzeugt werden. Wie erwähnt, kann der Beschichtungsprozess ausschliesslich mit dem einen oder den mehreren Targetmaterialien erfolgen, oder nach deren Reaktion mit einem in den Prozessraum zwischen Sputterfläche 3_{S} und Substrat 4 eingelassenen Reaktivgas. An ein und demselben Target 3 mit Bereichen unterschiedlicher Materialien können gleichzeitig mehrere Materialien in den Prozessraum gesputtert werden, direkt zur Beschichtung oder nach Reaktion mit einem Reaktivgas im Prozessraum.

Um die Lebensdauer des Targets 3 zu verlängern und/oder die Sputterrate (Menge abgesputterten Materials pro Zeiteinheit) trotz Bildung des oder der Erosionsgraben beispielsweise konstant zu halten und damit die Beschichtungsrate (Menge am Substrat 4 pro Zeiteinheit abgelegten Materials) ist es bekannt und verbreitet, mindestens Teile der Magnetanordnung 5, dabei insbesondere das eine oder die mehreren vorgesehenen Magnetschleifenpaare entlang der Targetrückseite zu bewegen, sei dies durch zyklische lineare Bewegungen oder durch Rotationsbewegungen oder Pendelbewegungen. Damit wird das Magnetronmagnetfeld H entlang der Sputterfläche bewegt, um möglichst keine ausgeprägten lokalen Erosionsgräben zu erzeugen.

Wir nennen eine Magnetronquelle eine Einkreisquelle, wenn sie nur ein Magnetschleifenpaar hat. Wir nennen eine Magnetronquelle eine Zwei- oder Mehrkreis-Quelle, wenn die Magnetanordnung zwei oder mehr Magnetschleifenpaare hat. Es ist zu beachten, dass durchaus mit drei Magnetschleifen zwei Magnetschleifenpaare gebildet werden können.

Die vorliegende Erfindung geht nun aus von einem Verfahren zur Herstellung magnetronbeschichteter Substrate, bei welchem entlang des Targets, auf dessen dem Substrat abgewandter Rückseite, eine Magnetanordnung vorhanden ist, mittels welcher, entlang der Sputterfläche des Targets, mindestens eine in sich geschlossene Schleife eines tunnelförmigen Magnetfeldes erzeugt wird.

Es ist ein notorisches Problem vor allem bei Einsatz grossflächiger Targets, an dem oder an den sputterbeschichteten Substraten eine gewollte Schichtdickenverteilung zu erzielen und über der Zeit beizubehalten, dabei vor allem eine gleichförmige Schichtdickenverteilung. Dabei besteht eines der Probleme darin, dass aufgrund der Targeterosion die Beschichtungsverhältnisse dynamisch sind, d.h. während der Lebensdauer bzw. Einsatzdauer des Targets wechseln. Wenn während der Lebensdauer eines betrachteten Targets viele Substrate beschichtet werden, so wirkt sich die angesprochene Dynamik je nach Beschichtungszeit der einzelnen Substrate darauf möglicherweise nur wenig aus, während dann, wenn die Schichtdickenverteilung über die ganze Targetlebensdauer betrachtet wird, wie wenn nur ein einziges Substrat beschichtet würde, oft eine ausgeprägte Änderung der Schichtdickenverteilung beobachtet wird.

### Definition

Wir definieren als Beschichtungszeit eine betrachtete Zeitspanne bis hin zur Targetlebensdauer, unabhängig davon, wie viele einzelne Substrate in der betrachteten Zeitspanne mit demselben Target beschichtet werden.

Drehende Einkreis-Magnetronquellen mit Herz- oder Mäanderförmigen Magnetschleifenstrukturen decken den grössten Teil der Anwendungen im Bereich des Magnetronsputterns ab. Verstellbare Einkreis-Magnetronquellen zur Verteilungsoptimierung der Sputterrate über der Beschichtungszeit werden z.B. in der US 5 188 717 beschrieben. Statische Zweikreis-Magnetronquellen sind beispielsweise aus der WO 98/03696 oder der US 5 997 697 bekannt. Zweikreis-Magntronquellen mit Schaltmechanismus, um von Sputtern durch eines der Magnetschleifenpaare auf Sputtern an einem zweiten umzuschalten, sind in der WO 01/63643 beschrieben.

Aufgrund der limitierten Abdeckung grosser Targetflächen beispielweise von 1200 cm² ist es oft sehr schwierig, mittels drehenden Einkreis-Magnetronquellen eine erwünscht gleichmässige Verteilung der Sputterrate sowie der Beschichtungsrate und schliesslich der Schichtdicken am Substrat über die Beschichtungszeit zu erreichen. Dabei werden oft mäander- oder herzförmige Strukturen des Magnetschleifenpaars eingesetzt, die jedoch auf grossen Targetflächen den Nachteil haben, dass sie entweder mehrere Wendepunkte haben oder weite Bereiche des Targets nur ungenügend überstreichen. Insbesondere enge Radien der Magnetschleifenpaare führen zudem bei erhöhter Geschwindigkeit, wie Drehzahl des Magnetsystems, zu hohen Wirbelstromverlusten. Diese sind einerseits durch die Motorleistung auszugleichen und führen anderseits zu einer Abschwächung des Magnetronmagnetfeldes.

Statische Zweikreis-Magnetronquellen, wie in der WO 98/03696 oder der US 5 997 697 beschrieben, haben den Nachteil, dass statische Erosionsprofile in der Sputterfläche eingeprägt werden. Wie eingangs erwähnt wurde, zeigt sich vor allem, dass sich mit zunehmendem Absputtern des Targets die Sputterrate, Beschichtungsrate und damit auch Schichtdickenverteilung am Substrat ändern. Daher ist grundsätzlich ein Mechanismus erforderlich, welcher eine Verstellung primär der Sputterratenverteilung am Target und über dessen Lebensdauer erlaubt. Dies wird häufig dadurch gelöst, dass Magnetgruppen der Magnetanordnung lateral, d.h. entlang der Targetrückseite 3_{R}, verschoben werden, wie beispielsweise aus der WO 02/47110 bekannt. Nachteilig daran ist, dass dem drehenden System mit den Magnetschleifenpaaren ein weiterer Antrieb überlagert werden muss, für den die Energiezufuhr beispielsweise über elektrische Schleifringe zu realisieren ist. Durch Verschieben der erwähnten Magnetgruppen entstehen Unwuchten, die durch geeignete Massnahmen auszugleichen sind. Drehende Zweikreis-Magnetronquellen mit einem Schaltmechanismus für selektive Aktivierung der einen oder der anderen Magnetschleifenpaare, wie in der WO 01/63643 beschrieben, haben eine hohe Belastung der elektromechanischen Antriebe zur Folge.

Es ist Aufgabe der vorliegenden Erfindung, ein Verfahren eingangs genannter Art bzw. eine Magnetronquelle vorzuschlagen, bei welchen bzw. woran während dem Sputterbetrieb - der Beschichtungszeit - die Sputterratenverteilung entlang der Sputterfläche in situ verstellt werden kann und dabei die Nachteile bekannter Verfahren bzw. Magnetronquellen mit den diesbezüglichen Ansätzen, vermieden werden. Hierzu zeichnet sich erfindungsgemäss das Verfahren eingangs genannter Art dadurch aus, dass zur Einstellung der Sputterratenverteilung der Abstand eines Teils der Magnetanordnung zur Targetrückseite verändert wird.

Das erfindungsgemäβe verfahren ist in Anspruche 1 berchriben.

Bei diesem Verfahren wird die Magnetanordnung entlang der Rückseite des Targets rotiert wird. Dadurch ergibt sich eine Verteilung der Sputterwirkung des tunnelförmigen Magnetronmagnetfeldes entlang der Sputterfläche.

Eine weitere gute Realisation des erfindungsgemässen Verfahrens besteht darin, dass ein Teil einer umlaufenden Magnetschleife abstands verändert wird. Damit ergibt sich eine Veränderung der Sputterintensität im Bereich des mit der Schleife miterzeugten Magnetronmagnetfelds.

Eine weitere gute Realisierung besteht darin, dass der Abstand einer ganzen Magnetschleife verändert wird, ggf. kombiniert mit der Veränderung eines Teils der betrachteten oder einer anderen Magnetschleife.

Eine weitere gute Realisierung besteht darin, ggf. kombiniert mit den vorerwähnten Realisierungen, den Abstand eines Magnetschleifenpaares zu verändern, vor allem angezeigt, wenn die Magnetronquelle eine Zwei- oder Mehrkreisquelle ist. Dann können die entsprechenden Abstände auch an mehr als einem der Magnetschleifenpaare verändert werden.

Die erfindungsgemässe Verstellung des erwähnten Abstandes wird bei Magnetronquellen realisiert, bei denen die Magnetanordnung entlang der Targetrückfläche rotiert wird, z.B. um eine homogene Schichtdickenverteilung während der Beschichtungszeit bis hin zur Lebensdauer des Targets zu erreichen. Erfindungsgemäß wird mit zunehmender Beschichtungszeit der Abstand eines Teiles der Magnetanordnung, der näher am Targetrand ist als ein weiterer Teil der Magnetanordnung, vergrössert und/oder der Abstand des weiteren Teils verringert.

Bei allen erwähnten Realisationen ist es weiter gut, die Sputterleistung konstant zu halten. Eine weitere gute Idee ist es, bei konstant gehaltener Sputterleistung die Entladespannung zwischen einer Anode und dem Target zu erfassen, sie mit einem Sollwert zu vergleichen und in Funktion des Vergleichsresultates den Abstand des Teiles zu stellen. Im Weiteren ist es auch eine gute Idee, das Target in Zonen unterschiedlichen Materialien zu unterteilen und das Verhältnis der Sputterraten der beiden Materialien durch die erwähnte Abstandsverstellung einzustellen.

Eine erfindungsgemässe Magnetronquelle ist in Anspruch 9 definiert und hat ein Target mit Sputterfläche und, entlang der der Sputterfläche abgewandten Targetrückfläche, eine Magnetanordnung. Die obgenannte Aufgabe wird daran gelöst dadurch, dass der Abstand eines Teils der Magnetanordnung zur Targetrückfläche mittels eines gesteuerten Hubantriebes verstellbar ist.

Dabei im erfindungsgemäss die Magnetanordnung mit einem Bewegungsantrieb wirkverbunden, mittels welchem sie entlang der Targetrückfläche rotiert wird.

Ein weiteres gutes, mit den erwähnten ohne weiteres kombinierbares Konzept ist es, wenn ein Teil einer Magnetschleife mit dem gesteuerten Hubantrieb wirkverbunden ist. Eine weitere gute Idee für das Konzept der erfindungsemässen Magnetronquelle, ggf. mit den vorerwähnten kombiniert, besteht darin, eine ganze Magnetschleife mit dem erwähnten gesteuerten Hubantrieb zu verstellen. Auch dieses Konzept lässt sich ggf. mit den vorerwähnten kombinieren, ebenso wie das gute weitere Konzept, ein Magnetschleifenpaar mit dem gesteuerten Antrieb wirkzuverbinden. Ein gutes weiteres Konzept besteht darin, an der Quelle und bezüglich der Targetrückfläche ein äusseres Magnetschleifenpaar sowie ein inneres Magnetschleifenpaar vorzusehen und mindestens eines der Schleifenpaare bezüglich einer Drehachse exzentrisch auszubilden und mit einem bezüglich der Drehachse wirkenden Drehantrieb wirdzuverbinden.

Erfindungsgemäß ist eine Steuerung vorgesehen, mittels welcher der Abstand eines Teils der Magnetanordnung, der weiter aussen am Target positioniert ist als ein weiterer Teil der Magnetanordnung, während der Beschichtungszeit vergrössert wird und/oder der Abstand des weiteren Teiles verringert wird.

Die Erfindung wird anschliessend anhand von Beispielen und mit Hilfe von Figuren weiter erläutert.

Es zeigen:
- Fig. 2a: schematisch eine perspektivische Ansicht einer ersten Ausführungsform eines Verfahrens Zur Herstellung magnetronsberdeichtetes Substrate bzw. einer Magnetronquelle,
- Fig. 2b: weiterhin schematisch eine Seitenansicht auf die in Fig. 2a dargestellte Anordnung,
- Fig. 2c: weiterhin schematisch zwei Varianten der Magnetanordnungen, z.B. an einer Anordnung gemäss Figur 2a, zur Bildung des Magnetronfeldes,
- Fig. 3: in einer Darstellung analog zu derjenigen von Figur 2a eine weitere Ausführungsform,
- Fig. 4: in einer Ansicht, analog zu derjenigen von Figur 2b schematisch eine weitere Ausführungsform,
- Fig. 5: in einer Darstellung analog zu derjenigen von Figur 4 eine weitere Ausführungsform,
- Fig. 6: weiterhin in einer Darstellung, analog zu denjenigen der Figuren 4 bzw. 5 eine weitere Ausführungsform,
- Fig. 7: weiterhin in Darstellung, analog zu denjenigen gemäss den Figuren 4 bis 6 eine noch weitere Ausführungsform der Erfindung,
- Fig. 8: in einer Darstellung, analog zu denjenigen der Figuren 4 bis 7 eine weitere Magnetschleifenanordnung, woran Vorkehrungen, wie sie anhand der Figuren 2 und 3 beschrieben wurden, realisiert werden,
- Fig. 9: weiterhin in der erwähnten Darstellung eine weitere Ausführungsform ,
- Fig. 10: schematische eine Realisationsform einer erfindungsgemässen Sputterquelle, prinzipiell gemäss der Ausführungsvariante von Figur 9 konzipiert,
- Fig. 11: eine Aufsicht auf eine erfindungsgemäss eingesetzte Magnetanordnung,
- Fig. 12: den Verlauf (a) des Erosionsprofils an einem kreisförmigen Target an der Anordnung gemäss Figur 10, bei einem konzentrischen Magnetschleifenpaar und einem exzentrischen, und den Verlauf (b) bei exzentrischer Anordnung beider Magnetschleifenpaare ohne Verstellung des Magnethubes,
- Fig. 13: Schichtdickenverteilungsverläufe (a, b) bei unterschiedlich eingestellten Hüben,
- Fig. 14: schematisch ein Erosionsprofil an einem kreisscheibenförmigen Target zur Diskussion eines anzustrebenden Erosionsprofils,
- Fig. 15: in Darstellung analog zu derjenigen von Figur 10, eine erfindungsgemässe Anordnung in einer Ausführungsform prinzipiell gemäss Figur 7,
- Fig. 16: die normierte Schichtdickenverteilung an einem Substrat mit Sputterleistung als Parameter,
- Fig. 17: schematisch ein Signalfluss/Funktionsblock-Diagramm einer Ausführungsform zur elektrischen Führung der erfindungsgemässen Magnetronquelle,
- Fig. 18: beispielsweise in Aufsicht vereinfacht, die Magnetanordnung an einer erfindungsgemässen Einkreismagnetronquelle,
- Fig. 19: die sich mit der Magnetanordnung gemäss Figur 18 ergebenden Schichtdickenverteilungen in Funktion der Abstandverstellung.

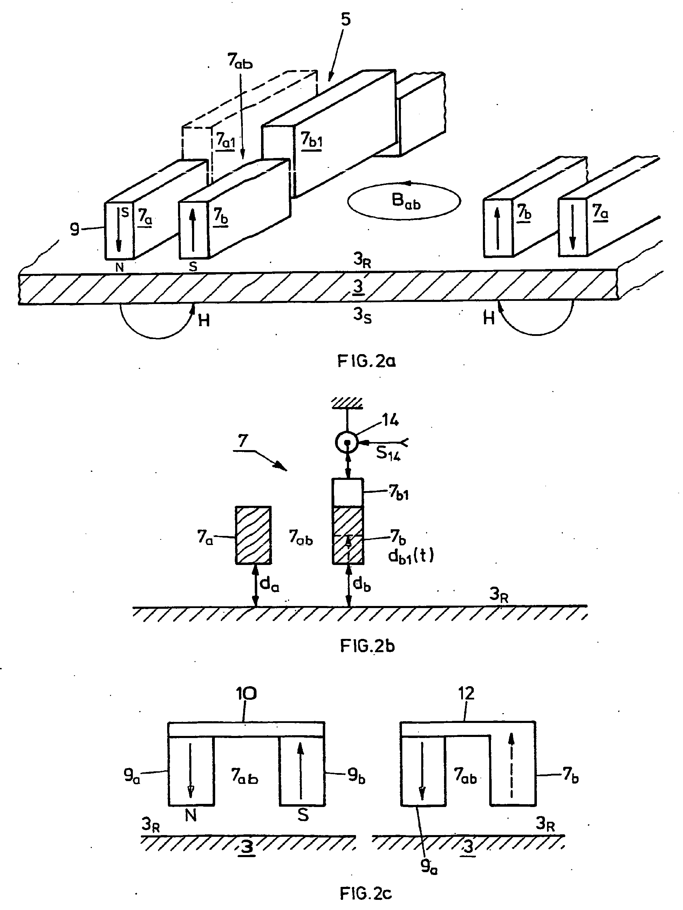

In Fig. 2a ist in schematisierter, perspektivischer Ansicht eine erste Ausführungsform eines Verfahrens Zur Herstellung magnekromberchichtek substrate bzw. einer Magnetronquelle dargestellt, in Fig. 2b, weiterhin schematisiert, die Seitenansicht auf die in Fig. 2a dargestellte Anordnung. Ein Target 3 hat substratseitig (Substrat nicht dargestellt) eine Sputterfläche 3_{S} und, dem Substrat abgewandt, eine Rückseite 3_{R}. Im Bereich der Rückfläche 3_{R} ist eine Magnetanordnung 5 vorhanden, welche mindestens eine, gemäss den Figuren 2 eine, in sich geschlossene Schleife eines tunnelförmigen Magnetfeldes H an der Sputterfläche 3_{S} erzeugt, das dem Fachmann durchaus geläufige Magnetronmagnetfeld H. In den Figuren 2 ist eine Einkreis-Magnetronquelle dargestellt. Hierzu hat die Magnetanordnung 5 eine erste, im Wesentlichen geschlossen umlaufende Magnetschleife 7a sowie eine zweite 7b, welche innerhalb der ersterwähnten liegt. Mindestens die eine der beiden Magnetschleifen 7a, 7b, ist mindestens weitestgehend mittels Permanentmagneten 9 aufgebaut, beispielsweise gemäss den Figuren 2 die äussere Magnetschleife 7a. Die erwähnte, beispielsweise äussere Magnetschleife 7a liegt mit der einen Magnetpolarität - beispielsweise N - der Targetrückfläche 3R gegenüber. Die zweite Magnetschleife 7b liegt jedenfalls der Targetrückfläche 3R mit der zweiten Magnetpolarität, beispielsweise S, gegenüber. Wie sich aus Fig. 2c ohne weiteres ergibt, ist die Realisation des Magnetschleifen-Paares 7_{ab} so, dass entlang der Targetrückfläche 3R eine umlaufende Zone der einen magnetischen Polarität entsteht sowie eine diesbezüglich innen oder aussen umlaufende zweite Zone der zweiten magnetischen Polarität. Hierzu sind an beiden Schleifen Permanentmagnete 9 vorgesehen, auf der der Targetrückseite 3R abgewandten Seite eine ferromagnetische Verbindung 10. Alternativ sind jeweils, ggf. auch abschnittsweise, entlang den Magnetschleifen betrachtet, an der einen, beispielsweise der äusseren, Permanentmagnete 9a vorhanden und die der Targetrückfläche 3R zugewandte zweite magnetische Polarität an der anderen Schleife, beispielsweise der inneren 7b, wird durch ein ferromagnetisches Joch 12 gebildet.

Betrachtet entlang dem Paar 7 können sich die Konstellationen gemäss Fig. 2c abwechseln, ebenso, mit Blick auf die Realisation mit Joch 12, die Anordnung der Permanentmagnete.

Gemäss den Figuren 2, insbesondere Fig. 2b, wird nach dem hier dargestellten Ausführungsbeispiel mittels eines Antriebs 14, gesteuert an einem Steuereingang S₁₄, der Abstand d_{b1}(t) eines Teiles 7_{b1} einer der Magnetschleifen des Paares 7 bezüglich der Targetrückfläche 3_{R} gesteuert verändert. In Fig. 2b bezeichnet dₐ den Abstand der Magnetpolfläche der einen Magnetschleife 7a von der Targetrückfläche 3_{R}, der Abstand d_{b} derjenige der zweiten Magnetschleife 7b und d_{b1} der gesteuert veränderliche Abstand des Teiles 7_{b1} an mindestens einer der beiden Schleifen, beispielsweise an der inneren. Die Wirkung des durch das Paar 7_{ab} gebildeten Magnetronmagnetfeldes H wird gesteuert verändert. Selbstverständlich ist es durchaus möglich, an der betrachteten Magnetschleife beide Teile relativ zueinander und beide Teile bezüglich der Targetrückfläche 3_{R} gesteuert abstandszubewegen, d.h. beispielsweise und mit Blick auf Fig. 2a, Teil 7b anzuheben und gleichzeitig den übrigen Teil der betrachteten Magnetschleife abzusenken. Wesentlich ist, dass betrachtet entlang dem Magnetschleifenpaar 7_{ab} die Abstandsverhältnisse der Magnetpolflächen bezüglich der Targetrückseite durch gesteuerte Abstandsveränderung an den Magnetschleifen in der Zeit verändert werden.

So ist es beispielsweise, wie in Fig. 2a dargestellt, eine gute Idee, in einem betrachteten Abschnitt entlang des Paares 7_{ab} an beiden Magnetschleifen, gleich oder ungleich lange Teile, 7ₐ₁, 7_{b1}, gesteuert bezüglich ihres Abstandes zur Targetrückfläche 3R zu verändern, in gleicher Richtung gleich oder ungleich, oder in inverser Richtung gleich oder ungleich.

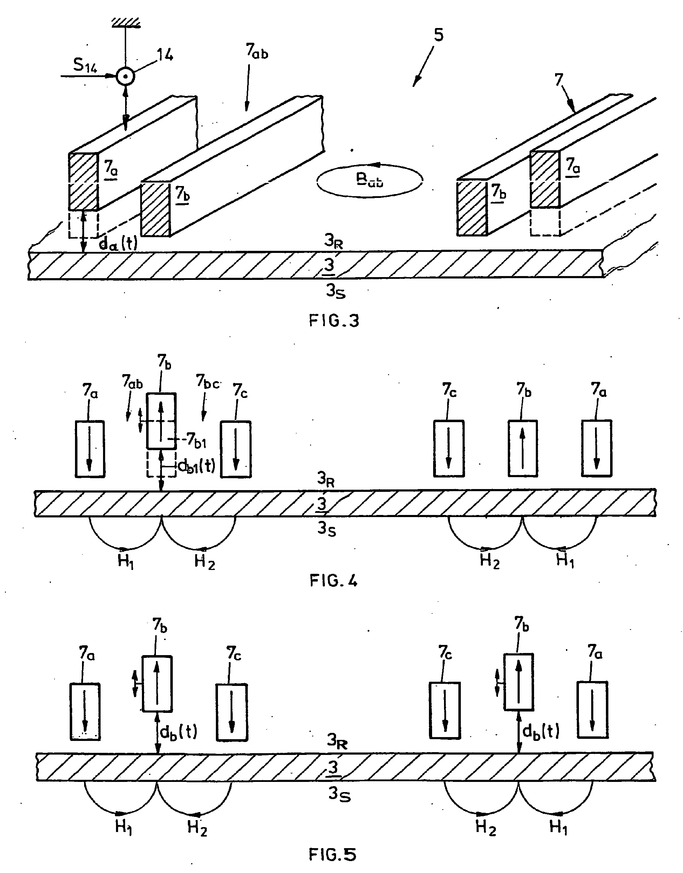

In einer Darstellung analog zur derjenigen von Fig. 2a ist in Fig. 3 eine weitere gute Ausführungsform dargestellt. Wie ohne weiteres ersichtlich, wird hierbei am Paar 7_{ab} der Abstand zwischen der gesamten Polfläche und Target an der einen, z.B. der äusseren Magnetschleife 7a, dₐ(t) mit dem Antrieb 14 gesteuert in der Zeit eingestellt und damit wiederum die Wirkung des erzeugten tunnelförmigen Magnetfeldes H. Auch hier können ggf. die Abstandsverhältnisse beider gesamten Magnetschleifen 7a und 7b in gleicher Richtung gleich, in gleicher Richtung ungleich, in jeweils inverser Richtung gleich oder ungleich gesteuert eingestellt werden.

Die Ausführungsform gemäss Fig. 3 zeigt wiederum eine Einkreis-Magnetronquelle.

In Fig. 4 ist, in Ansicht analog zur Darstellung von Fig. 2b, eine weitere gute Ausführungsform dargestellt. Hier sind, allgemein, eine ungerade Anzahl, wie dargestellt drei, Magnetschleifen 7ₐ bis 7_{c} vorhanden, welche gemeinsam zwei Schleifenpaare 7_{ab}, 7_{bc} der Magnetordnung 5 bilden. Die Polung der mittleren Magnetschleife 7b ist invers derjenigen der beiden benachbarten. Dadurch werden beim dargestellten Ausführungsbeispiel die zwei umlaufende Schleifen des tunnelförmigen Magnetronmagnetfeldes H₁, H₂ gebildet. In Analogie zu den Ausführungen zu Fig. 2 wird bei der Ausführungsform gemäss Fig. 4 der Abstand d_{b1}(t) mindestens eines Teils 7_{b1} der mittleren Magnetschleife 7b mittels eines gesteuerten Antriebes (nicht dargestellt) verändert, während der oder die übrigen Teile der betrachteten Magnetschleife 7b bezüglich der Rückfläche 3R des Targets 3 auf konstantem Abstand gehalten werden.

Es zeigt Fig. 5 in Darstellung analog zu Fig. 4 eine weitere gute Ausführungsform - analog der in Fig. 3 dargestellten - bei welcher die ganze mittlere Magnetschleife 7, wie mit d_{b}(t) dargestellt, mit einem gesteuerten Antrieb (nicht dargestellt) bezüglich des Abstandes zur Rückfläche 3R des Targets 3 verändert wird.

Bei Vorgehen gemäss den Fig. 4 und 5 wird im Wesentlichen auf beide Magnetronmagnetfelder H₁ und H₂ durch gezielte Verstellung des Abstandes d_{b}(t) bzw. d_{b1}(t) gleich eingewirkt.

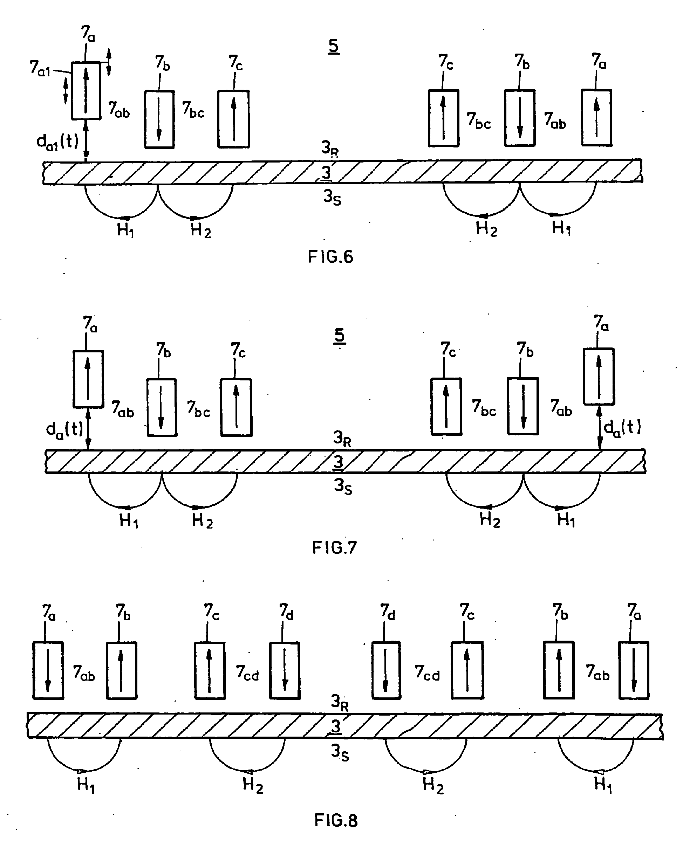

Gemäss der Ausführungsform nach Fig. 6 wird, wie nun ohne weiteres verständlich, ein Teil 7ₐ₁ der äusseren Magnetschleife 7a mit einem (nicht dargestellten) gesteuerten Antrieb bezüglich seines Abstands dₐ₁(t) bewegt, während der übrige Teil der Magnetschleife 7a auf konstantem Abstand gehalten ist, ebenso wie die Schleifen 7b, 7c.

Bei der ebenfalls guten Ausführungsform gemäss Fig. 7 wird der Abstand dₐ(t) der ganzen äusseren Magnetschleife 7a mittels eines gesteuerten Antriebes (nicht dargestellt) und bezüglich der Targetrückfläche 3R verändert.

Bei den Ausführungsformen nach den Figuren 4 bis 7 handelt es sich um Zweikreis-Magnetronquellen. Durch Vorsehen entsprechend gesteuerter Antriebe können alle einzelnen anhand der Figuren 2 bis 7 beschriebenen Ausführungsformen an einer Magnetronquelle ggf. kombiniert eingesetzt werden.

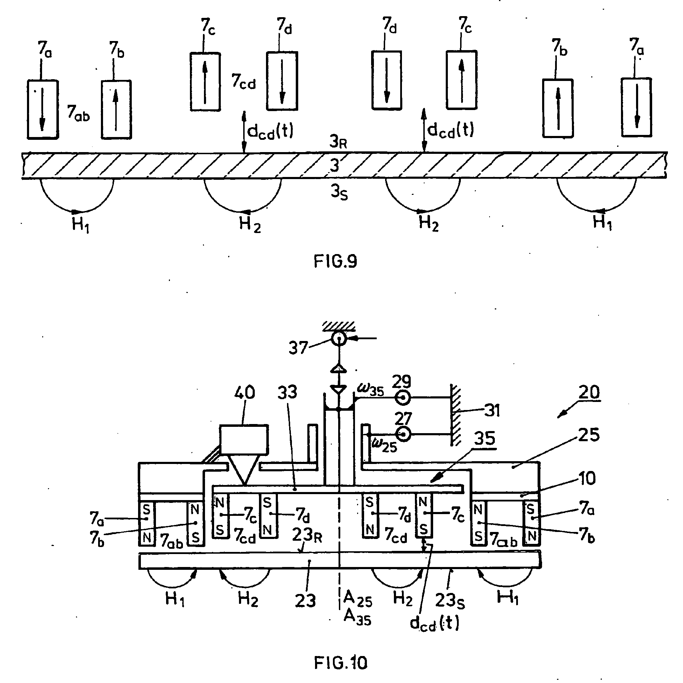

Während durch die Abstandsverstellung bei den Ausführungsformen gemäss den Figuren 4 bis 7, d.h. an Zweikreis-Magnetronquellen, die benachbarten Magnetronmagnetfelder H in gegenseitiger Abhängigkeit verstellt werden, nämlich generell gesprochen bei Schwächung des einen Feldes das andere verstärkt wird und umgekehrt, ist dies bei den nachfolgend dargestellten, guten Ausführungsformen weniger ausgeprägt der Fall. Bei der ebenfalls guten Ausführungsform nach Fig. 8 sind vier, allgemeiner eine gerade Anzahl, ineinander liegender Magnetschleifen vorgesehen, 7a bis 7d. Von der innersten oder äussersten Magnetschleife, dazu senkrecht fortschreitend, sind jeweils zwei sich folgende Magnetschleifen an der Bildung eines Magnetschleifenpaares beteiligt, wie in Fig. 8 mit 7_{ab}, 7_{cd} dargestellt, welche ein Magnetronmagnetfeld, H1 bzw. H2, bilden. An beiden Paaren 7_{ab}, 7_{cd} können je die anhand der Figuren 2 und 3 beschriebenen Ausführungsformen realisiert sein, an einem der Paare oder an beiden. Zudem kann aber in einer weiteren, guten Ausführungsform und wie in Fig. 9 dargestellt die mittels eines (nicht dargestellten) gesteuerten Antriebes der Abstand d_{cd}(t) eines ganzen Schleifenpaares, gemäss Fig. 9 des inneren 7_{cd}, erfindungsgemäss verstellt werden. Es ist auch möglich und eine gute Idee, den Abstand beider vorgesehener Magnetschleifenpaare gesteuert verstellbar mit entsprechenden Antrieben auszubilden und diese Abstände richtungsgleich gleich, richtungsgleich ungleich, in Gegenrichtung gleich oder in Gegenrichtung ungleich zu verstellen, ggf. beliebig gezielt kombiniert.

Bisher wurden bei den Ausführungsformen gemäss den Figuren 2 bis 9 die vorgesehenen Magnetanordnungen mit den Magnetschleifen, abgesehen von der Abstandsverstellung, als stationär bezüglich der Targetrückfläche 3R betrachtet. In allen Ausführungsformen ist es ein gutes Konzept, zusätzlich zur Realisation der Abstandsverstellung, mindestens Teile der Magnetanordnung 5 entlang der Targetrückseite 3R mittels eines entsprechenden (nicht dargestellten) Antriebs zu bewegen. Demnach ist es ein gutes Konzept, gemäss Fig. 2a das Paar 7_{ab} wie mit der Bewegungsbahn B_{ab} schematisch dargestellt zyklisch entlang der Magnetronrückfläche 3R zu bewegen. Dasselbe gilt bei der Ausführungsform gemäss Fig. 3. Dabei ist es ggf. auch ein gutes Konzept, bei den betrachteten Einkreis-Magnetronquellen nach Fig. 2 und 3, die beiden das Paar bildenden Magnetschleifen auf entlang der Rückfläche 3_{R} auf unterschiedlichen Bewegungsbahnen relativ zueinander zu bewegen.

Bei der Ausführungsform gemäss den Figuren 4 bis 7, d.h. bei der Realisation einer Zweikreis-Magnetronquelle mit Magnetschleifentrippeln, ergeben sich gute Konzepte durch
- Bewegen aller vorgesehener Magnetschleifen gleich entlang der Rückfläche 3_{R};
- Bewegen der mittleren Magnetschleife bezüglich den benachbarten beiden Magnetschleifen;
- Bewegen einer oder beider der äussersten und innersten Magnetschleifen des Trippels gleich oder ungleich bezüglich der mittleren Magnetschleife des Trippels.

Bei den Ausführungsformen gemäss den Figuren 8 bzw. 9 ist es ein gutes Konzept
- alle vorgesehenen Magnetschleifenpaare gleich entlang der Targetrückfläche 3_{R} zu bewegen, oder
- ein Magnetschleifenpaar bezüglich des anderen zu bewegen.

Je nach Wahl des Konzeptes, mit den Magnetschleifen das Magnetronmagnetfeld zu formen bzw. entlang der Sputterfläche 3_{S} des Targets 3 zu bewegen, werden die erwähnten Bewegungsmöglichkeiten kombiniert eingesetzt und entsprechende, gesteuerte Antriebe vorgesehen.

Die anhand der Figuren 2 bis 9 vorgestellten Magnetschleifen können kreisförmig, oval, elliptisch, ja genähert rechteckförmig umlaufen, in Aufsicht auf die Sputterfläche 3_{S} betrachtet, oder herz- bzw. nierenförmig bzw. mäanderformig.

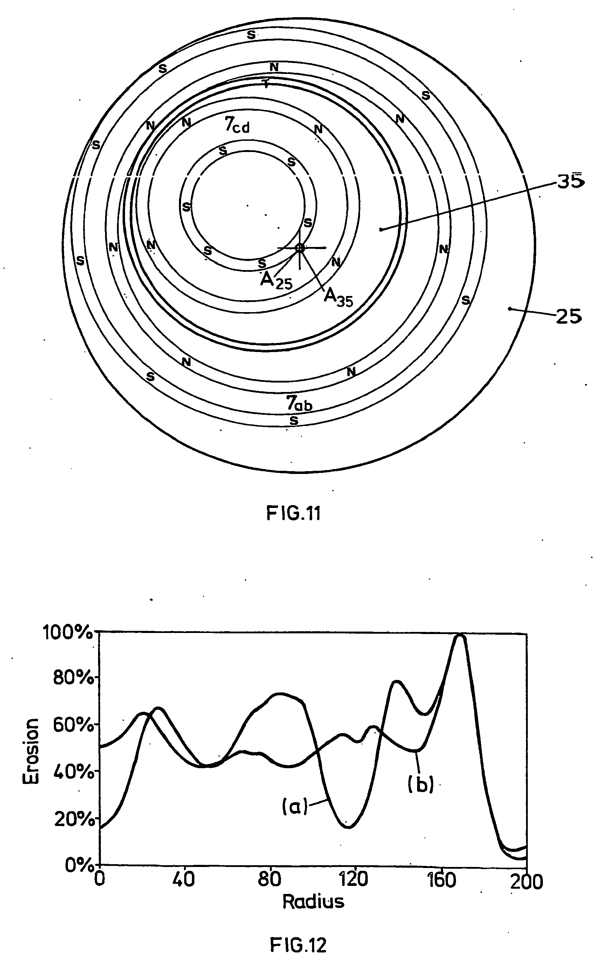

In Fig. 10 ist schematisch eine gute Realisationsform einer erfindungsgemässen Quelle 20 prinzipiell gemäss Fig. 9 dargestellt. Sie hat ein Target 23 mit Sputterfläche 23_{S} und Rückfläche 23_{R}. Das äussere Magnetschleifenpaar 7_{ab} gemäss Fig. 9 ist über ein ferromagnetisches Joch 10 gemäss Fig. 2a an einem äusseren Träger 25 montiert. Mittels eines Drehantriebes 27, nur schematisch dargestellt, wird der äussere Träger 25 um die Achse A₂₅ in Drehung versetzt. Mittels eines weiteren Drehantriebes 29 bezüglich dem nur schematisch dargestellten Quellengehäuse wird ein innerer Träger 35 in Drehung versetzt, beim dargestellten Beispiel um die Achse A₃₅, welche hier mit der Drehachse A₂₅ zusammenfällt. Der innere Träger 35 hat eine Rückplatte 33, dem Target 23 zugewandt, aus ferromagnetischen Material und trägt die Magnetschleifen 7_{c} und 7_{d}, welche gemeinsam das Paar 7_{cd} bilden. Bezüglich der Drehachse A₂₅ ist das Magnetschleifenpaar 7_{ab} konzentrisch am äusseren Träger 25 montiert, während das Magnetschleifenpaar 7_{cd} am inneren Träger 33 bezüglich der Drehachse A₃₅ exzentrisch montiert ist. Mittels eines schematisch dargestellten steuerbaren Hubantriebs 37 wird der innere Träger 35 bezüglich des Abstandes d_{cd}(t) zur Rückfläche 23_{R} des Targets 23 verstellt. Die Rotationsgeschwindigkeiten ω₃₅ und ω₂₅ bzw. Rotationsrichtungen des äusseren bzw. inneren Trägers 25, 35 können dabei gleich oder unterschiedlich gewählt werden. Ein gutes Konzept ergibt sich aber, wenn, wie in Aufsicht auf die Magnetanordnung in Fig. 11 dargestellt, das Magnetschleifenpaar 7_{ab} am äusseren Träger 25 exzentrisch und, wie dargestellt, beispielsweise kreisförmig realisiert ist, das Magnetschleifenpaar 7_{cd} an dem um die Achse A₃₅ drehenden Innenträger 35 ebenfalls exzentrisch. In Fig. 12 zeigt der Verlauf (a) an einem kreisförmigen Target 23 mit Durchmesser 400 mm das Erosionsprofil bei konzentrischer Anordnung eines der beiden Matnetschleifepaare, gemäss Fig. 10 beispielsweise des äusseren 7_{ab} und exzentrischer Anordnung des anderen Magnetschleifenpaares, gemäss Fig. 10 des Paares 7_{cd}. Der Verlauf (b) zeigt das Erosionsprofil, wenn beide, Innen- und Aussenpaare 7_{ab} und 7_{cd}, gemäss Fig. 11 exzentrisch bezüglich der zusammenfallenden Drehachsen A₂₅, A₃₅ realisiert sind. Es zeigt sich, dass bei der Anordnung nach Fig. 11 im Zwischenbereich zwischen innerem Magnetschleifenpaar 7_{cd} und äusserem 7_{ab} kein wesentlich vermindert erodierter Bereich entsteht. Durch optimierte Exzentrizität der betrachteten Magnetschleifenpaare lässt sich eine optimale Erosionsprofil-Überdeckung erreichen. Bei Ausbildung gemäss Fig. 11 ergibt sich zwangsläufig, dass die Rotationsantriebe 27 und 29 gemäss Fig. 10 mit gleichen Drehgeschwindigkeiten betrieben werden. Durch den mit dem Antrieb 37 gesteuert eingestellten Hub und damit Veränderung des Abstandes d_{cd}(t) lässt sich, wie noch zu zeigen sein wird, eine noch gleichmässigere Erosions- bzw. Sputterverteilung realisieren und damit eine optimale erwünschte Schichtdickenverteilung am Substrat erreichen, oder es lässt sich die Targetnutzung optimieren durch möglichst uniformen Abtrag der Targetfläche.

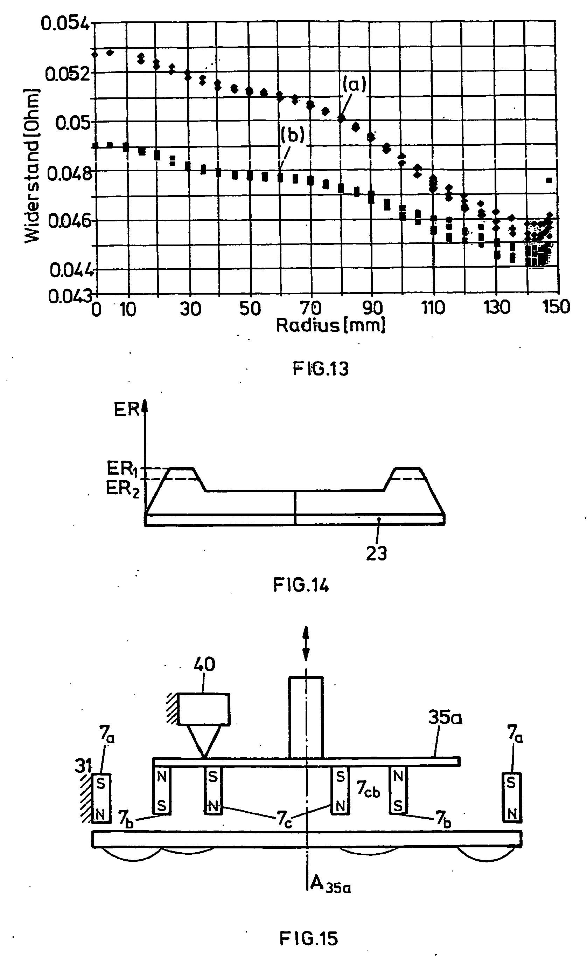

Die bei unterschiedlichen Hüben bzw., mit Blick auf Fig. 10 des Abstandes d_{cd}(t), erreichte Schichtdickenverteilung ist in Fig. 13 an einem kreisförmigen Substrat mit Durchmesser 300 mm erreichte Schichtdickenverteilung anhand des Flächenwiderstandes einer aufgesputterten Kupferschicht dargestellt. Demnach entspricht ein hoher Widerstandswert einer dünnen Schicht und umgekehrt. Als Magnetanordnung wurde die doppelt exzentrische Anordnung nach Fig. 11 eingesetzt. Das Resultat gemäss Verlauf (a), bei welchem im Zentrumsbereich des Substrates die Kupferschicht wesentlich dünner ist als im Peripheriebereich, wurde ein Hub des inneren Paares 7_{cd} entsprechend dem Abstand d_{cd}(t) gemäss Fig. 10 eingestellt, der gleich ist wie der Abstand dₐ des äusseren Paares 7_{ab}. Dann wurde der Abstand d_{cd}(t) (inneres Schleifenpaar!) um 0,5 mm verringert, was zu einer Erhöhung der Sputterrate im Zentrumsbereich des Targets und damit zu einer Erhöhung der Beschichtungsrate am Substrat führte, mit dem Resultat einer gemäss Verlauf (b) von Fig. 13 wesentlich verbesserten Schichtdickenverteilung am Substrat.

Wurde (in Fig. 13 nicht dargestellt) der Hub d_{cd}(t) um weitere 0,5 mm reduziert, so ergab sich eine höchst gleichförmige Schichtdickenverteilung am Substrat, indem in der letzten Beschichtungsphase im Zentrum des Targets die Sputterrate nochmals erhöht wurde und dadurch im Zentrumsbereich des Substrates die resultierende Schichtdicke weiter erhöht wurde, mit gemäss Fig. 13 weiter reduziertem Flächenwiderstand der Kupferschicht im Substratzentrumsbereich.

Aus Fig. 13 ist ersichtlich, wie durch Zeitsteuerung des Abstandes an Teilen der Magnetfeld erzeugenden Magnetanordnung einerseits der Verlauf der Sputterrate und damit Beschichtungsrate und damit der nach vorgegebener Zeit resultierendem Schichtdickenverteilung am Substrat fein eingestellt werden kann. Zum Erhalt der Resultate gemäss Fig. 13 wurde die Entladespannung an der Magnetronsputterquelle nicht beeinflusst und die zugeführte elektrische Entladeleistung konstant gehalten.

Für die zeitabhängige Steuerung des Abstandes d_{cd}(t) an der Anordnung nach Fig. 10 mit zwei exzentrischen Magnetschleifenpaaren 7_{ab} und 7_{cd} gemäss Fig. 11 können folgende Überlegungen hilfreich sein, wenn am Substrat eine möglichst homogene Schichtdickenverteilung erzielt werden soll, wobei sich dem Fachmann damit analoge Gedankengänge an anders ausgebildeten, erfindungsgemässen Magnetronquellen und zur erreichenden Verteilungen eröffnen: Das an einem kreisscheibenförmigen Target für optimierte Schichtdickenverteilung am Substrat anzustrebende Erosionsprofil soll vorerst anhand von Fig. 14 diskutiert werden. Ohne gezielte Abstandssteuerung ergibt sich mit der Anordnung nach Fig. 10 und Magnetanordnung nach Fig. 11 eine am Aussenbereich erhöhte Erosionsrate ER, die zur Randeffektkorrektur durchaus erwünscht ist. Es kommt aber in diesem Aussenbereich aufgrund der Bildung des ausgeprägten Erosionsgrabens zu einer immer höheren Sputterrate, so dass im Laufe der Zeit, im Aussenbereich des Targets, die relative Erosionsintensität zurückzunehmen ist. Dies, um, über der Zeit, eine homogene Schichtdickenverteilung am Substrat zu erreichen. Rücknahme der Erosionsintensität im Aussenbereich des Targets ist relativ zur Erosionsintensität im Zentrumsbereich des Targets zu betrachten. Deshalb kann entweder die Erosionsintensität im Aussenbereich des Targets zurückgenommen werden oder die Erosionsintensität im Zentrumsbereich erhöht werden. Bei den Erläuterungen zu Fig. 13 wurde letzterwähnter Weg beschrieben.

Es ist also - mit Blick auf Fig. 14 - die relative Sputterintensität bzw. Sputterrate im Aussenbereich des Targets von einem zu Beginn höheren Wert ER1 auf einen gegen Ende der Beschichtungszeit tieferen Wert ER2 zurückzunehmen. Als grober Ansatz, wie viel die Abstandsreduktion an d_{cd}(t) des inneren Trägers sein soll bzw. die Abstandserhöhung am äusseren Träger, lässt sich wie folgt vorab abschätzen: Es wird vorerst am Ende einer gegebenen Beschichtungszeit, z.B. der Targetlebensdauer, die Erosionstiefendifferenz von äusserem und innerem Erosionsgraben gemessen. Dies bei vorgegebenen fixen Abständen des äusseren und des inneren Trägers 25 bzw. 35 gemäss Fig. 10. Ist diese Erosionstiefendifferenz bestimmt, beispielsweise 7 mm höhere Erosionstiefe im Targetrandbereich, so wird während der selben Beschichtungszeit die Sputterintensität im Aussenbereich des Targets durch eine relative Hubveränderung von 7 mm, relativ zurückgenommen, d.h. eine Abstandserhöhung des Aussenträgers 35 um 7 mm bzw. eine Abstandsreduktion des Innenträgers 25 um 7 mm während der Beschichtungszeit angestrebt. Die Hubveränderung kann dabei lediglich am Aussenträger oder lediglich am Innenträger erfolgen oder kombiniert gegenläufig am Innen- und Aussenträger.

Die zu führende Hubänderung über der Zeit muss mit hoher Genauigkeit erfolgen und ist vom angestrebten Erosionsprofil-Verlauf über der Beschichtungszeit, dem Targetmaterial, der Targetdicke, den bezüglich Schichtdickenverteilung gestellten Anforderungen am Substrat sowie der Sputterleistung abhängig. Zur Überwachung und Steuerung der angesteuerten Abstandsverhältnisse wird eine oder werden mehrere, direkte oder indirekte, In-situ-Abstandsmessungen vorgenommen. In Fig. 10 ist schematisch eine Sensoranordnung 40 hierzu dargestellt. Weil bei dieser Ausführungsform der äussere Träger nicht hubverstellt wird, misst die Anordnung den momentan eingestellten Abstand zwischen äusserem Träger 25 und innerem Träger 35 und damit den Verlauf bzw. den Momentanwert von d_{cd}(t). Die Sensoranordnung 40 kann z.B. auf dem Prinzip der Triangulationsmessung arbeiten, kann als kapazitiver oder optischer Sensor ausgebildet sein, als mechanischer Fühler etc. Dabei ist es eine gute Idee, eine berührungslos messende Sensoranordnung einzusetzen, damit die Magnetanordnung gegenüber dem Target nicht elektrisch isoliert sein muss, womit die Abstände zwischen den Polflächen der Magnetanordnung und der Targetrückseite auch minimal gewählt bzw. gestellt werden können.

Grundsätzlich wird mit dem erfindungsgemässen Vorgehen ein erwünschter Sputterratenverteilungs-Verlauf über der Zeit einstellbar. Wenn somit beispielsweise mit einer Anordnung nach Fig. 10 das innere Magnetschleifenpaar 7_{cd} entlang eines ersten Targetbereiches aus einem ersten Material geführt wird, hingegen das äussere Magnetschleifenpaar 7_{ab} entlang eines Targetbereiches aus einem zweiten Material, das Target aus zwei Zonen unterschiedlicher Materialien besteht, so kann mit dem erfindungsgemässen Vorgehen auch die relative Beschichtungsrate der beiden Materialien am Substrat eingestellt werden.

In Fig. 15 ist in einer Darstellung analog zu derjenigen von Fig. 10 eine Ausführungsform schematisch dargestellt, welche der prinzipiell in Fig. 7 dargestellten entspricht. Auch hier ist eine Zweikreis-Magnetronquelle dargestellt. Nur die äusserste Magnetschleife 7ₐ wird bezüglich der zwei innen liegenden Magnetschleifen 7_{b} und 7_{c} abstandsverstellt. Es ist die äussere Magnetschleife 7ₐ bezüglich des Quellengehäuses 31 fix montiert. Das innere Magnetschleifenpaar 7_{cb} ist an einem drehgetriebenen Träger 35ₐ montiert, bezüglich der Drehachse A₃₅ₐ exzentrisch. Aufgrund der Ausführungen zu Fig. 10 ist die vereinfacht dargestellte Ausführungsform gemäss Fig. 15 für den Fachmann ohne weiteres verständlich.

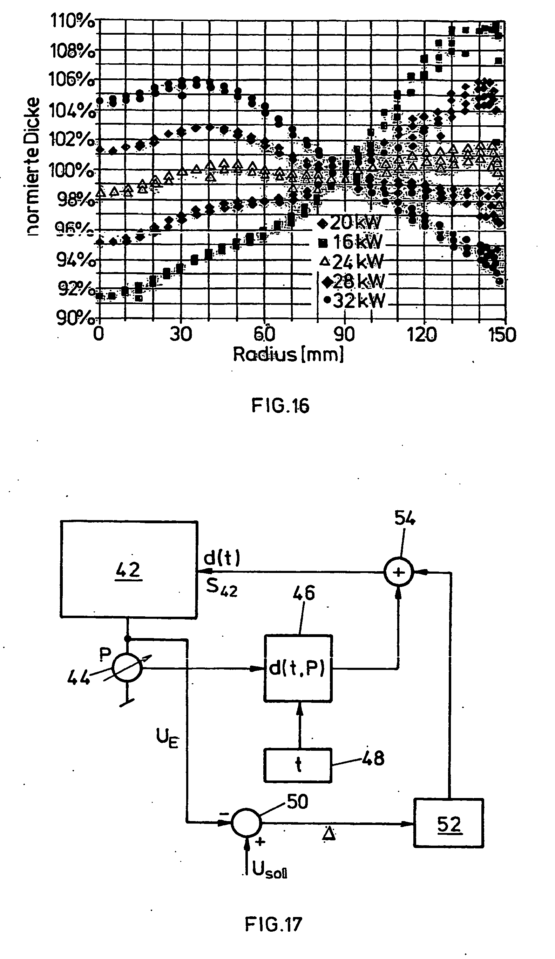

In Fig. 16 ist, mit der Sputterleistung als Parameter, die normalisierte Schichtdickenverteilung am Substrat und über die Lebensdauer des Targets als Beschichtungszeit dargestellt. Der Abstand des äusseren Magnetschleifenpaares 7_{ab} gemäss Fig. 10 ist 1 mm grösser ist als der Abstand des inneren Magnetschleifenpaares 7_{cd}. Der Verlauf (a) wurde bei einer Sputterleistung von 32 kW gemessen, (b) bei 28 kW, Verlauf (c) bei 24 kW, (d) bei 16 kW und schliesslich der Verlauf (e) bei 20 kW.

Daraus ist eine starke Abhängigkeit der resultierenden Schichtdickenverteilung von der eingestellten Sputterleistung erkenntlich. Daraus folgt, dass es ein gutes Konzept ist, bei Durchführung der erfindungsgemässen zeitlich gesteuerten Verstellung des Abstandes mindestens eines Teils der Magnetronfeld erzeugenden Magnetanordnung bezüglich der Targetrückfläche, die Sputterleistung konstant zu halten.

Im Weiteren besteht eine eindeutige Abhängigkeit zwischen Entladungsspannung U_{E} und momentaner Sputterratenverteilung am Target. Die Erfahrung zeigt, dass die Entladespannung mit zunehmender Targetnutzung abnimmt aufgrund der zunehmenden Erosion im Aussenbereich des Targets. Damit ergibt sich die Möglichkeit, die Entladespannung als gemessene Regelgrösse zu erfassen, mit einem Sollwert zu vergleichen und durch Nachführung des Abstandes des äusseren Magnetschleifenpaares in regelndem Sinne konstant zu halten.

Grundsätzlich ergibt sich die Aussage, dass die Entladespannung bei einer Mehrkreis-Sputterquelle im Wesentlichen durch die Sputterwirkung desjenigen Magnetschleifenpaares bestimmt wird, welches die höchste Sputterintensität am Target bewirkt.

Üblicherweise wird vorgängig, mit der Sputterleistung als Parameter, aufgenommen, wie die erfindungsgemässe Abstandsverstellung über der Zeit vorgenommen werden sollte, um in der Beschichtungszeit eine erwünschte Schichtdickenverteilung am Substrat zu erzielen. Die so gewonnenen Kennlinien werden als Tabellen abgespeichert. Die Abstandsverstellung wird dann, sputterleistungsabhängig, nach den abgespeicherten Verläufen geführt. Die Regelung der Entladespannung U_{E} durch Stellen des jeweiligen Abstandsverhältnisses erfolgt dann ggf. als Arbeitspunkt-Regelung.

In Fig. 17 ist anhand eines schematischen Signalfluss/Funktionsblock-Diagrammes ein mögliches Konzept zur elektrischen Führung der erfindungsgemässen Magnetronquelle dargestellt. Die Magnetronquelle 42 hat einen Steuereingang S₄₂ für den erfindungsgemäss über der Zeit verstellten Abstand mindestens eines Teils der das Magnetromagnetfeld erzeugenden Magnetanordnung. Die Quelle wird elektrisch mit der einstellbaren konstanten Leistung P von einem Generator 44 gespiesen. Die bei Betrieb eines betrachteten Targets eingestellte elektrische Leistung P wird einem Tabellenspeicher 46 zugeführt, worin für die verschiedene Leistungseinstellungen die je als erforderlich vorab bestimmten, zeitlichen Abstandsfunktionen als d(t,P) abgespeichert sind. Ab Beginn des Sputterbeschichtens mit dem betrachteten Target steuert ein Zeitnehmen 48 das Auslesen des der aktuellen Beschichtungszeit entsprechenden Abstandswertes aus Tabellenspeicher 46. Über den Abstandsteuereingang S₄₂ wird an der Magnetronquelle der geforderte Abstandswert eingestellt. Über den z.B. anhand von Fig. 10 beschriebenen Positionssensor 40 kann das exakte Einhalten des momentan geforderten Abstandes geregelt werden. Dieser Positions-Regelkreis ist in Fig. 17 nicht dargestellt. Im Weiteren wird die Entladespannung U_{E} als Istgrösse gemessen und mit einer vorgegebenen Sollentladespannung U_{SOLL} an einem Vergleicher 50 verglichen. Das Vergleichsresultat wird als Regeldifferenz Δ über einen Regler 52 und eine Superpositionseinheit 54 als Stellsignal an den Eingang S₄₂ der Quelle 42 gelegt. Damit wird der Arbeitspunkt durch Regelung der Entladespannung auf dem vorgegebenen Wert aus Tabelle 46 gehalten.

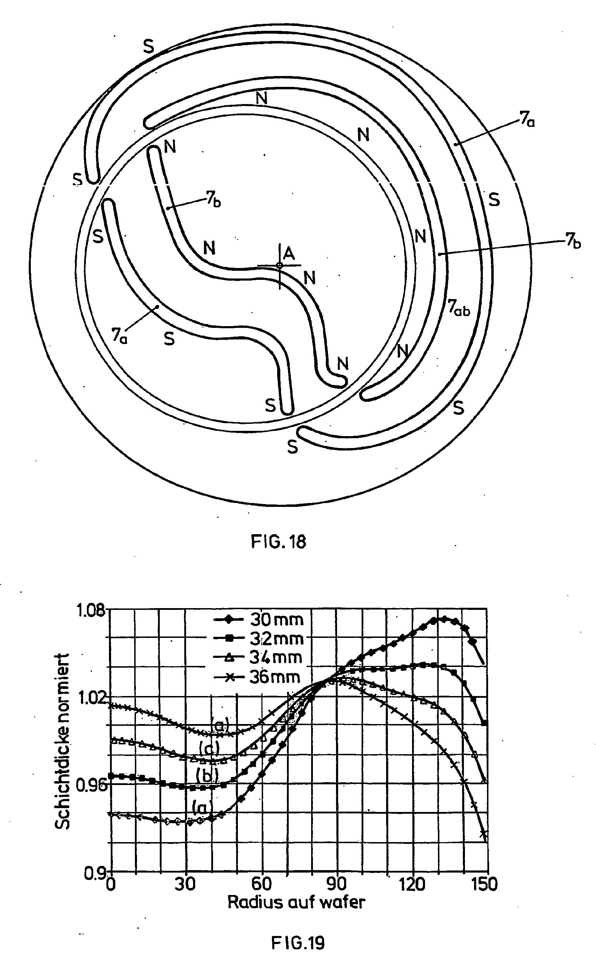

In Fig. 18 ist die Magnetanordnung 5 an einer Einkreis-Magnetronquelle dargestellt, mit mäanderförmigen Magnetschleifen 7ₐ und 7_{b}. Beide Magnetfeldschleifen 7ₐ und 7_{b}, das Paar 7_{ab}, drehen um die Achse A. In Fig. 19 sind die resultierenden Schichtdickenverteilungen an einem 300 mm Durchmesser Substrat dargestellt, wenn, gemäss Verlauf (a), der Abstand der Schleife 7_{b} von der Targetrückseite 2 mm grösser ist als der Abstand des äusseren Magnetkreises 7ₐ und sukzessive gemäss den Verläufen (b), (c), (d) um 2 mm verringert wird. Daraus ist erkenntlich, dass auch bei einer Einkreis-Quelle resp. bei erfindungsgemässem Vorgehen an einer Einkreis-Quelle, wie anhand der Figuren 2 und insbesondere 3 gezeigt, eine Steuerung der momentanen Sputterrate und mithin der momentanen Beschichtungsrate am Substrat möglich ist und damit, über eine betrachtete Beschichtungszeit bis hin zur Targetlebensdauer, die Einstellung bzw. Beibehaltung einer erwünschten Schichtdickenverteilung am Substrat, dabei insbesondere einer homogenen, d.h. gleichförmigen, sichergestellt werden kann.

Mit Blick auf die Ausführungsform nach Fig. 10 realisiert nach Fig. 11 wurde im Weiteren festgestellt, dass sich bei dieser Konfiguration einer Zweikreis-Magnetronquelle eine Reduktion der Wirbelstromverluste, verglichen mit der Einkreis-Quelle nach Fig. 18, ergibt, die eine Verringerung der notwendigen Antriebsmotorenleistung für den jeweiligen Drehantrieb von ca. 20 % ermöglicht. Zusätzlich wird durch die Reduktion von Wirbelströmen das resultierende Streufeld im Umkreis der drehenden Magnetanordnung reduziert und damit die potentielle Gefahr der Störung umliegender Anlagenkomponenten vermindert.

## Patentansprüche

1. Verfahren zur Herstellung magnetronbeschichteter Substrate, bei welchem entlang des Targets auf dessen dem Substrat abgewandten Rückseite eine Magnetanordnung vorhanden ist, mittels welcher entlang der Sputterfläche des Targets mindestens eine in sich geschlossene Schleife eines tunnelförmigen Magnetronmagnetfeldes erzeugt wird und die Magnetanordnung entlang der Targetrückseite rotiert wird, dabei ein Abstand zwischen der Magnetanordnung und der Targetrückseite verändert wird, **dadurch gekennzeichnet, dass** mit zunehmender Beschichtungszeit der Abstand eines Teiles der Magnetanordnung, der näher am Targetrand ist als ein weiterer Teil der Magnetanordnung, vergrössert wird und/oder der Abstand des weiteren Teils verringert wird.

2. Verfahren nach Anspruch 1, wobei der Teil ein Teil einer umlaufenden Magnetschleife ist.

3. Verfahren nach einem der Ansprüche 1 oder 2, wobei der Teil eine ganze Magnetschleife ist.

4. Verfahren nach einem der Ansprüche 1 bis 3, wobei der Teil ein Magnetschleifenpaar ist.

5. Verfahren nach einem der Ansprüche 1 bis 4, wobei die der Quelle zugeführte elektrische Leistung konstant gehalten wird.

6. Verfahren nach einem der Ansprüche 1 bis 5, wobei bei konstant gehaltener Sputterleistung die Entladespannung erfasst wird, mit einem Sollwert verglichen wird und der Abstand in Abhängigkeit vom Vergleichsresultat verstellt wird.

7. Verfahren nach einem der Ansprüche 1 bis 6, wobei, mit der Sputterleistung als Parameter, die Funktion der zeitabhängigen Abstandseinstellung ermittelt und abgespeichert wird und die Abstandsverstellung mit der Funktion in der Zeit gesteuert wird.

8. Verfahren nach einem der Ansprüche 1 bis 7, wobei das Target Zonen unterschiedlicher Materialien hat und das Verhältnis der Sputterraten der Materialien mit der Abstandsverstellung eingestellt wird.

9. Magnetronquelle (20,42) mit einem Target (23) mit Sputterfläche (23_{S}) entlang der der Sputterfläche abgewandten Targetrückseite (23_{R}) eine Magnetanordnung (7a,7b), die mit einem Bewegungsantrieb (27) wirkverbunden ist, mittels welchem sie entlang der Targetrückseite getrieben rotiert wird und mit einem gesteuerten Hubantrieb (37) an der Magnetanordnung, **dadurch gekennzeichnet, dass** der gesteuerte Hubantrieb mit einer Steuerung (S_{42,}52,54) wirkverbunden ist, welche dazu ausgelegt ist, in Funktion der Beschichtungszeit den Hubantrieb so zu steuern, dass der Abstand zwischen einem Teil der Magnetanordnung, der am Target weiter aussen liegt als ein weiterer Teil, und der Targewinckseite mit der Zeit vergrössert wird und/oder der Abstand des weiteren Teils verringert wird.

10. Magnetronquelle nach Anspruch 9, wobei ein Teil einer Magnetschleife mit dem gesteuerten Hubantrieb wirkverbunden ist.

11. Magnetronquelle nach einem der Ansprüche 9 oder 10, wobei eine ganze Magnetschleife mit dem gesteuerten Hubantrieb wirkverbunden ist.

12. Magnetronquelle nach einem der Ansprüche 9 bis 11, wobei ein Magnetschleifenpaar mit dem gesteuerten Hubantrieb wirkverbunden ist.

13. Magnetronquelle nach einem der Ansprüche 9 bis 12, wobei mindestens zwei Magnetschleifenpaare vorhanden sind und mindestens eines der Paare bezüglich einer Drehachse exzentrisch ausgebildet ist und mit einem Bewegungsantrieb um die Drehachse wirkverbunden ist.

14. Magnetronquelle nach einem der Ansprüche 9 bis 13, wobei mit dem Teil eine Hubmesseinrichtung (40) wirkverbunden ist.

15. Magnetronquelle nach einem der Ansprüche 9 bis 14, wobei sie an einen elektrischen Generator (44) angeschlossen ist, der im Betrieb im Wesentlichen konstante Leistung abgibt.

16. Magnetronquelle nach einem der Ansprüche 9 bis 15, wobei eine Messanordnung für die Entladespannung (u_{E}) zwischen einer Anode der Quelle und dem Target vorgesehen ist, deren Ausgang mit einem Vergleicher (50) wirkverbunden ist, dessen zweitem Eingang eine Vorgabeeinheit (U_{Soll}) zugeschaltet ist, wobei der Ausgang des Vergleichers mit einem Steuereingang des gesteuerten Hubantriebes wirkverbunden ist.

17. Magnetronquelle nach einem der Ansprüche 9 bis 16, wobei das Target aus mindestens zwei Zonen unterschiedlicher Materialien besteht.

## Claims

1. Method of manufacturing magnetron-coated substrates, in which a magnet arrangement is provided along the rear side of the target away from the substrate, by means of which at least one closed loop of a tunnel-shaped magnetron magnetic field is generated along the sputtering surface of the target and the magnet arrangement is rotated along the target rear side, whereby a distance between the magnet arrangement and the target rear side is changed, **characterised in that** with increasing coating time the distance of a part of the magnet arrangement which is nearer to the edge of the target than a further part of the magnet arrangement is increased and/or the distance of the further part is decreased.

2. Method according to claim 1, wherein the part is a part of a circumferential magnetic loop.

3. Method according to claim 1 or 2, wherein the part is a whole magnetic loop.

4. Method according to one of claims 1 to 3, wherein the part is a pair of magnetic loops.

5. Method according to one of claims 1 to 4, wherein the electrical power supplied to the source is maintained constant.

6. Method according to one of claims 1 to 5, wherein the discharge voltage is measured at constantly-maintained sputtering power, is compared with a desired value, and the distance is adjusted in dependency of the comparison result.

7. Method according to one of claims 1 to 6, wherein, with the sputtering power as a parameter, the function of the time-dependent distance adjustment is determined and stored, and the distance adjustment is controlled with the function over time.

8. Method according to one of claims 1 to 7, wherein the target has zones of different materials, and the relationship of the sputtering rates of the materials is adjusted with the distance adjustment.

9. Magnetron source (20, 42) with a target (23) with sputtering surface (23_{S}), along the target rear side (23_{R}) away from the sputtering surface a magnet arrangement (7a, 7b) which is operatively connected with a motive drive (27), by means of which the magnet arrangement is rotatingly driven along the target rear side and with a controlled linear actuator (37) on the magnet arrangement, **characterised in that** the controlled linear actuator is operatively connected with a controller (S₄₂, 52, 54), which is arranged to control the linear actuator in function of the coating time such that the distance between one part of the magnet arrangement, which lies further outwards on the target than a further part, and the target rear side, is increased with time and/or the distance of the further part is reduced.

10. Magnetron source according to claim 9, wherein a part of a magnetic loop is operatively connected with the controlled linear actuator.

11. Magnetron source according to one of claims 9 or 10, wherein a whole magnetic loop is operatively connected with the controlled linear actuator.

12. Magnetron source according to one of claims 9 to 11, wherein a pair of magnetic loops are operatively connected with the controlled linear actuator.

13. Magnetron source according to one of claims 9 to 12, wherein at least two pairs of magnetic loops are present and at least one of the pairs is eccentrically disposed in relation to an axis of rotation and is operatively connected with a motive drive around the axis of rotation.

14. Magnetron source according to one of claims 9 to 13, wherein a linear measurement arrangement (40) is operatively connected with the part.

15. Magnetron source according to one of claims 9 to 14, wherein it is connected with an electrical generator (44) which in operation outputs substantially constant power.

16. Magnetron source according to one of claims 9 to 15, wherein a measurement arrangement for the discharge voltage (Q_{E}) is provided between an anode of the source and the target, the output of which is operatively connected with a comparator (50), the second input of which is connected to a set-point unit (Uₛₒₗₗ), wherein the output of the comparator is operatively connected with a control input of the controlled linear actuator.

17. Magnetron source according to one of claims 9 to 16, wherein the target comprises at least two zones of differing materials.

## Revendications

1. Procédé pour fabriquer des substrats revêtus par magnétron, dans lequel un agencement d'aimants est prévu le long du côté arrière de la cible éloigné du substrat, par moyens duquel au moins une boucle fermée d'un champ magnétique de magnétron en forme de tunnel est générée le long de la surface de pulvérisation de la cible et l'agencement magnétique est mis en rotation le long du côté arrière de la cible, par lequel une distance entre l'agencement magnétique et le côté arrière de la cible est variée, **caractérisé en ce que**, lorsque le temps de revêtement augmente, la distance d'une partie de l'agencement magnétique qui est plus proche au bord de la cible qu'une autre partie de l'agencement magnétique est augmentée et/ou la distance de l'autre partie est diminuée.

2. Procédé selon la revendication 1, dans lequel la partie est une partie d'une boucle magnétique périphérique.

3. Procédé selon l'une des revendications 1 ou 2, dans lequel la partie est une boucle magnétique entière.

4. Procédé selon l'une des revendications 1 à 3, dans lequel la partie est une paire des boucles magnétiques.

5. Procédé selon l'une des revendications 1 à 4, dans lequel la puissance électrique fournie à la source est maintenue constante.

6. Procédé selon l'une des revendications 1 à 5, dans lequel la tension de décharge est mesurée à une puissance de pulvérisation maintenue constante, est comparée avec une valeur désirée, et la distance est variée en dépendance du résultat de la comparaison.

7. Procédé selon l'une des revendications 1 à 6, dans lequel, prenant la puissance de pulvérisation comme paramètre, la fonction du réglage en dépendance du temps est déterminée et sauvegardée, et la variation de distance est commandé dans le temps avec la fonction.

8. Procédé selon l'une des revendications 1 à 7, dans lequel la cible a des zones des matériaux différentes, et le rapport des taux de pulvérisation des matériaux est réglé par la variation de distance.

9. Source magnétron (20, 42) avec une cible (23) ayant une surface de pulvérisation (23_{S}), le long du côté arrière (23_{R}) de la cible éloignée de la surface de pulvérisation un agencement d'aimants (7a, 7b) qui est en connexion opérative avec un entraîneur motrice (27), par moyens duquel l'agencement d'aimants est entraîné en rotation le long du côté arrière de la cible et avec un contrôleur de levage commandé (37) sur l'agencement d'aimants, **caractérisée en ce que** le contrôleur de levage commandé est en connexion opérative avec un dispositif de commande (S₄₂, 52, 54) agencé pour commander le contrôleur de levage en fonction du temps de revêtement tel que la distance entre une partie de l'agencement d'aimants, qui est plus proche au bord de la cible qu'une autre partie, et le côté arrière de la cible, est augmentée et/ou la distance de l'autre partie est diminuée.

10. Source magnétron selon la revendication 9, dans laquelle une partie d'une boucle magnétique est en connexion opérative avec le contrôleur de levage commandé.

11. Source magnétron selon l'une des revendications 9 ou 10, dans laquelle une boucle magnétique entière est en connexion opérative avec le contrôleur de levage commandé.

12. Source magnétron selon l'une des revendications 9 à 11, dans laquelle une paire de boucles magnétiques est en connexion opérative avec le contrôleur de levage commandé.

13. Source magnétron selon l'une des revendications 9 à 12, dans laquelle au moins deux paires de boucles magnétiques sont présentes et au moins l'une des paires est disposée excentriquement par rapport à un axe de rotation et est en connexion opérative avec un entraîneur motrice autour de l'axe de rotation.

14. Source magnétron selon l'une des revendications 9 à 13, dans laquelle un dispositif de mesure de levage est en connexion opérative (40) avec ladite partie.

15. Source magnétron selon l'une des revendications 9 à 14, dans laquelle elle est connectée à une génératrice électrique (44), qui émet en opération une puissance substantiellement constante.

16. Source magnétron selon l'une des revendications 9 à 15, dans laquelle un agencement de mesure pour la tension de décharge (U_{E}) entre une anode de la source et la cible est prévu, la sortie duquel étant en connexion opérative avec un comparateur (50), la seconde entrée duquel étant connectée à une unité de régulation (Uₛₒₗₗ), où la sortie du comparateur est en connexion opérative avec une entrée de commande du contrôleur de levage commandé.

17. Source magnétron selon l'une des revendications 9 à 16, dans laquelle la cible se compose d'au moins deux zones de matériaux différents.
